# EUROPEAN PATENT APPLICATION

(11) **EP 4 376 095 A1**
(43) Date of publication of application: **29.05.2024**
(21) Application number: 23211659.0
(22) Date of filing: 23.11.2023
(51) Int. Cl.: H01L 29/78, H01L 29/66

(54) **SEMICONDUCTOR TRANSISTOR WITH PRECISE GEOMETRIES AND RELATED MANUFACTURE METHOD THEREOF**

(30) Priority: 24.11.2022 US 202263427845 P
(71) Applicant: Invention And Collaboration Laboratory Pte. Ltd., Singapore 068914 (SG)
(72) Inventor: Lu, Chao-Chun, Taipei City 106 (TW)
(74) Representative: Straus, Alexander

(57) **Abstract**

A semiconductor transistor includes a semiconductor substrate with an original surface, an active region, a shallow trench isolation region, a shallow trench isolation region, a first conductive region and a second conductive region located within the active region, and a spacer. The active region is formed based on the semiconductor substrate and the active region has a fin structure. The shallow trench isolation region surrounds the active region and a gate structure of the semiconductor transistor crosses over the fin structure. The spacer contacts to a sidewall of the gate structure and on the fin structure. A width of the fin structure under the spacer is wider than that of the fin structure under the gate structure, the fin structure has a lateral profile along a direction substantially parallel to the original surface, and the lateral profile of the fin structure includes a rounded corner under the spacer.

## Description

### Field of the Invention

The present invention relates to a semiconductor transistor and a manufacture method thereof according to claims 1, 8.

### Background of the Invention

The most widely used semiconductor MOSFET (metal-oxide-semiconductor field-effect transistor) structure of various process nodes from 20nm down to 5nm is so-called "FinFET (Fin field-effect transistor) or Tride-gate FET". This kind of 3D (three dimensional) FET enables effective miniaturization of its planar area and enhances its performance, which are demanded by fulfilling Moore's Law. However, Table 1 shows state-of-the-art transistor density (unit: Million Transistor per mm²; MTr/mm²) of different manufacturer technologies and our calculation based on the semiconductor transistor density of Manufacturer A's 16nm node (28.88 MTr/mm²) if Moore's law is obeyed, and it is clear that, no matter for Manufacturer A or Manufacturer B, the increased number of transistors per unit area cannot meet the Moore's Law demand while the process nodes are scaled from 16nm to 3nm at all. For example, in Table 1 it is found that in a process node of 7nm and 5nm, the ideal target of the number of transistors is 150.88 MTr/mm² and 295.73 MTr/mm², respectively, but with the most of the state-of-the-art fabrication capabilities the realistic number of transistors per mm^2 is much lower than it should be. Table 1 is shown as follows:

**Table 1(source:https//www.anandtech.com/show/16656/ibm-creats-first-2nm-chip)**

| State-of-the-art transistor density (MTr/mm²) of different foundry technologies and calculation based on Morre's law | | | |
|---|---|---|---|
| Technology node | Foundry A | Foundry B | If obey Morre's law (below list calculation values based on transistor density of Foundry A's 16nm) |
| 16nm | 28.88 | | 28.88 |
| 14nm | | 33.32 | 37.72 |
| 10nm | 52.51 | 51,92 | 73.93 |
| 7nm | 91.2 | 95.08 | 150.88 |
| 5nm | 171.3 | | 295.73 |
| 4nm | | | 462.08 |
| 3nm | 292.21 | | 821.48 |

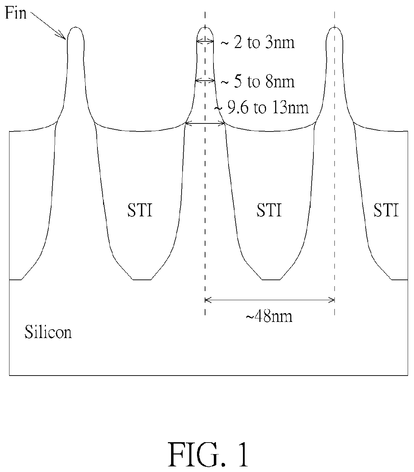

One reason of limiting the effectiveness of scaling the FinFET's planar area is due to scaling the pitch (fin width + fin-to-fin space) of the fin body. For example, a cross-section dimension of state-of-the-art technology node 14 nm FinFET is shown in FIG. 1, the fin body has a strange sharp shape: a small top area (~2 to 3nm), a wide body width in the middle (~5 to 8nm), a wider at the bottom of the fin body (~9 to 13nm) where is leveled with the bottom of the gate, and a very wide distance at the bottom of the STI (Shallow Trench Isolation, usually of oxide material) between two neighboring FinFET. There is a gradual transition in the vertical profile of the fin structure from the small top area to the very wide distance at the bottom of the STI. So the pitch could be ~48 nm depending on individual manufacturer/factory capabilities, about 3.5F where F represents the minimum feature size or the process node declared by the individual manufacturer. Some weaknesses are revealed here:
(1) The most important parameter affecting the FinFET performance and quality is surely the width of the fin body, but its variation is large and hard to control precisely as shown in the state-of-the-art FinFET technology.
(2) The shape of this fin "Hill" is very difficult to maintain its consistency and to minimize its variations.
(3) Due to this "Hill" both the width and the depth of the STI is hard to be optimized.
(4) The pitch occupies at least >3F to 5F, which hurts scaling of the semiconductor transistor's planar area.
(5) The key parameter for performance and leakage is affected by the shape and size of this sharp shape fin and hard to minimize their variations.
(6) The fin body could be easily bent or fall off as the dimension is getting narrower due to scaling, or the number of this kind of "Hill" fin is increasing significantly as more and more FinFETs must be fabricated on a larger and complex die.

However, the prior art has no good technology to solve the above-mentioned problems, so how to solve the above-mentioned problems in order to fit demands from the Moore's Law of more transistors per unit area and lower cost per transistor is a challenge.

### Summary of the Invention

The present invention aims at providing a semiconductor transistor and a manufacture method thereof that can make the semiconductor transistor have precise and well-controlled geometries (such as, shapes or dimensions of fin structure, fin width, source/drain regions, and/or metal plug connecting to the source/drain regions), thus reducing the area of the semiconductor transistor and preventing the collapse of the fin structure.

This is achieved by a semiconductor transistor and a manufacture method thereof according to claims 1, 8. The dependent claims pertain to corresponding further developments and improvements.

As will be seen more clearly from the detailed description following below, the claimed semiconductor transistor. The semiconductor transistor includes a semiconductor substrate, an active region, a shallow trench isolation region, a shallow trench isolation region, a first conductive region, a second conductive region, and a spacer. The semiconductor substrate has an original surface. The active region is formed based on the semiconductor substrate, and the active region has a fin structure. The shallow trench isolation region surrounds the active region, and a gate structure of the semiconductor transistor crosses over the fin structure. The first conductive region and the second conductive region of the semiconductor transistor are located within the active region. The spacer contacts to a sidewall of the gate structure and on the fin structure. A width of the fin structure under the spacer is wider than that of the fin structure under the gate structure, the fin structure has a lateral profile along a direction substantially parallel to the original surface, and the lateral profile of the fin structure includes a rounded corner under the spacer.

According to one aspect of the present invention, the first conductive region is limited by the shallow trench isolation region, and a width of the first conductive region is wider than that of the fin structure under the gate structure.

According to one aspect of the present invention, the fin structure includes a fin body and a fin base, the fin structure has a perpendicular profile along a direction substantially perpendicular to the original surface, and the perpendicular profile includes a step-like transition or non-gradual transition between the fin body and the fin base.

According to one aspect of the present invention, the lateral profile of the fin structure further provides another step-like transition or a non-gradual transition between the fin structure under the gate structure and the rounded corner.

According to one aspect of the present invention, the first conductive region is contacted to a first end of the fin structure, the second conductive region is contacted to a second end of the fin structure, and the first conductive region and the second conductive region are independent from the fin structure.

According to one aspect of the present invention, a bottom of the gate structure over the shallow trench isolation region is lower than a bottom of the first conductive region and/or the second conductive region.

According to one aspect of the present invention, at least two sides of the first conductive region or the second conductive region are contacted to a metal-containing region.

Another embodiment of the present invention provides a manufacture method. The manufacture method includes based on a semiconductor substrate, forming a fin structure which includes a fin body and a fin base; forming a gate structure over the fin structure; forming a gate spacer over the fin structure; and controlling a width of the fin body in the gate structure, such that the width of the fin body in the gate structure and outside the gate spacer is narrower than that of the fin body under the gate spacer, wherein the fin structure has a lateral profile along a direction substantially parallel to the original surface, and the lateral profile of the fin structure includes a rounded corner under the gate spacer.

According to one aspect of the present invention, the Step of forming the fin structure includes: defining the fin structure by a pad cover layer; based on the pad cover layer, using a first etching process to etch the semiconductor substrate to form the fin body; forming a side spacer layer to cover sidewalls of the fin body; and based on the pad cover layer and the spacer layer, using a second etching process to further etch the semiconductor substrate to form the fin base.

According to one aspect of the present invention, the Step of forming the gate structure includes: forming a STI region to surround the fin structure, wherein a top surface of the STI region is higher than an original surface of the semiconductor substrate; defining the gate structure by a patterned photo-resistance; and etching down portion of the STI region and portion of the pad cover layer in the gate structure.

According to one aspect of the present invention, the Step of forming the gate spacer over the fin structure includes: forming a polysilicon spacer covering sidewalls of the gate structure; forming a TiN layer and a Tungsten material to fill in rest portion of the gate structure; removing the polysilicon spacer to form canals in the gate structure; etching down the STI region within the canals; and forming the gate spacer to fill in the canals; and removing the TiN layer and the Tungsten material.

According to one aspect of the present invention, the Step of controlling the width of the fin body in the gate structure includes: etching down the STI region in the gate structure; removing the side spacer layer within the gate structure to reveal sidewalls of the fin body; and laterally etching the fin body, such that the width of the fin body in the gate structure and outside the gate spacer is narrower than that of the fin body under the gate spacer.

According to one aspect of the present invention, the manufacture method further includes removing the pad cover layer within the gate structure to reveal a top surface of the fin body; forming a EOT (Equivalent oxide Thickness) spacer on both the top surface and the sidewalls of the fin body; forming a gate structure to cover the top surface and the sidewalls of the fin body and the sidewall of the fin base in the gate structure; wherein the gate structure includes a gate dielectric layer and a gate conductive layer covering the fin body, the fin base, and the STI region within the defined gate structure.

According to one aspect of the present invention, the manufacture method further includes removing the pad cover layer outside the defined gate structure to reveal a first portion of the original surface of the semiconductor substrate; based on the first portion of the original surface, etching the semiconductor substrate to form a first trench; and based on the first trench, forming a first conductive structure of the semiconductor transistor.

According to one aspect of the present invention, the Step of forming the first conductive structure includes: forming a covering oxide layer based on the surface of the first trench; etching portion of the covering oxide layer to form a revealed sidewall of the semiconductor substrate; forming a doped semiconductor structure based on the revealed sidewall of the semiconductor substrate, wherein the doped semiconductor structure is confined by the STI region; and forming a metal structure to fill in the first trench and contact the doped semiconductor structure.

According to one aspect of the present invention, the doped semiconductor structure includes a lightly doped semiconductor region and a highly doped semiconductor region.

### Brief Description of the Drawings

The present invention is further illustrated by way of example, taking reference to the accompanying drawings thereof:
FIG. 1 is a diagram illustrating a cross section view of a conventional FinFET based on state-of-the-art technology node 14nm,
FIG. 2A is a flowchart illustrating a manufacturing method of a semiconductor transistor according to one embodiment of the present invention,
FIG. 2B, FIG. 2C, FIG. 2D, FIG. 2E, FIG. 2F are diagrams illustrating FIG. 2A,
FIG. 3, FIG. 4 are diagrams illustrating forming a Fin structure with a Fin body and a Fin base Based on a semiconductor substrate,
FIG. 5, FIG. 6, FIG. 7, FIG. 8, FIG. 9, FIG. 10 are diagrams illustrating defining a gate area over the Fin structure,
FIG. 11, FIG. 12 are diagrams illustrating thinning the Fin structure in the gate area,
FIG. 13 is a diagram illustrating forming a gate structure in the gate area,
FIG. 14, FIG. 15, FIG. 16, FIG. 17 are diagrams illustrating forming a source region and a drain region, and
FIG. 18, FIG. 19, FIG. 20 are diagrams illustrating the semiconductor transistor without thinned fin structure according to another embodiment of the present invention.

### Detailed Description

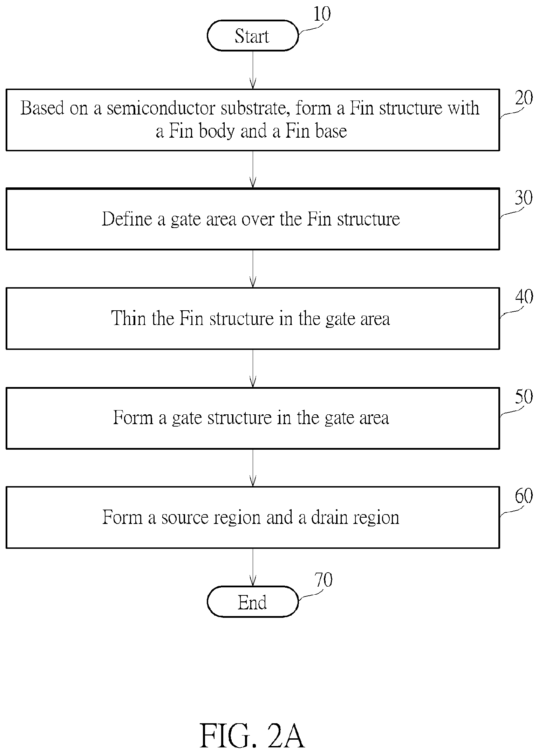

The present invention discloses a new manufacture method and its inventive principle to improve or eliminate the above-mentioned problems to achieve a new 3D FET structure which can have a smaller fin Pitch with a more precise fin width, thus reducing the planar of the semiconductor transistor so as to getting closer to the demands from the Moore's Law of more transistors per unit area and lower cost per transistor. The new FinFET or Tri-gate FET is named as RB-FinFET or RB-Tri-gate FET (RB: Rectangular body) which can be achieved by a manufacture method described in FIG. 2A. Detailed Steps are as follows:

| | |
|---|---|
| Step 10: | Start. |
| Step 20: | Based on a semiconductor substrate, form a Fin structure with a Fin body and a Fin base. |
| Step 30: | Define a gate area over the Fin structure. |
| Step 40: | Thin the Fin structure in the gate area. |
| Step 50: | Form a gate structure in the gate area. |
| Step 60: | Form a source region and a drain region. |
| Step 70: | End. |

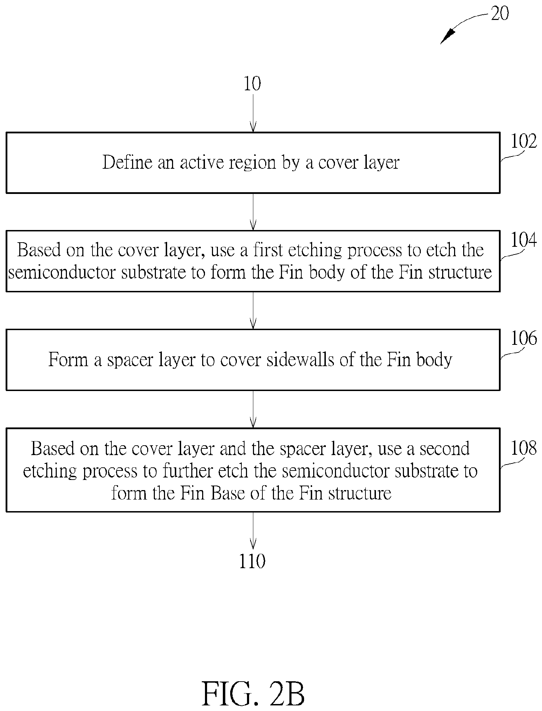

Please refer to FIG. 2B and FIG. 3 and FIG. 4. Step 20 could include:

| | |
|---|---|
| Step 102: | Define an active region by a cover layer (such as a composite layer with a pad-oxide layer 204 and a pad-nitride layer 206 shown in FIG. 3). |
| Step 104: | Based on the cover layer, use a first etching process to etch the semiconductor substrate to form the Fin body of the Fin structure (FIG. |
| | 3). |
| Step 106: | Form a spacer layer (such as a composite layer with an oxide spacer-1 208 and a nitride spacer-1 210) to cover sidewalls of the Fin body (FIG. 3). |
| Step 108: | Based on the cover layer and the spacer layer, use a second etching process to further etch the semiconductor substrate to form the Fin Base of the Fin structure (FIG. 4). |

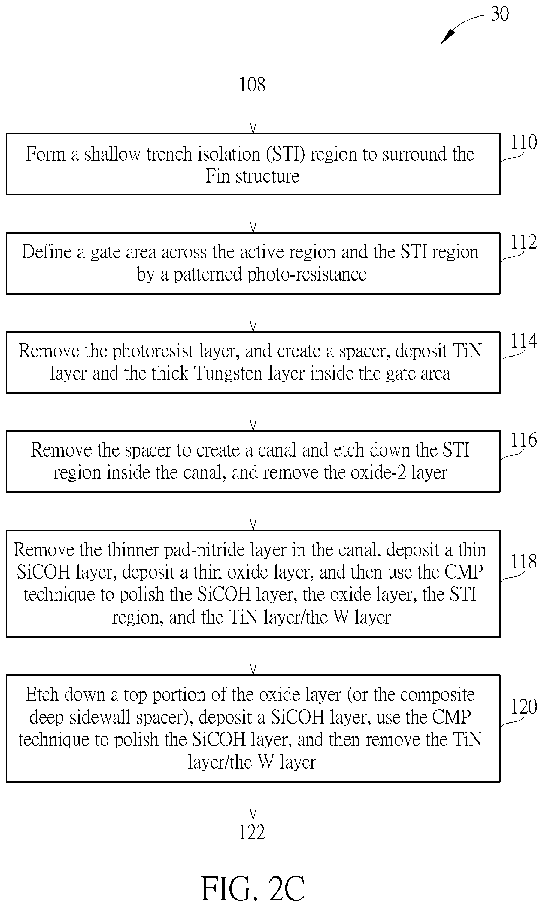

Then, please refer to FIG. 2C and FIG. 5, FIG. 6, FIG. 7, FIG. 8, FIG. 9, FIG. 10. Step 30 could include:

| | |
|---|---|
| Step 110: | Form a shallow trench isolation (STI) region 212 to surround the Fin structure (FIG. 5). |
| Step 112: | Define a gate area across the active region and the STI region 212 by a patterned photo-resistance which includes an oxide-2 layer 602 and a photoresist layer 604 (FIG. 6). |
| Step 114: | Remove the photoresist layer 604, and create a spacer 702, deposit TiN layer 704 and the thick Tungsten layer 706 inside the gate area (FIG. 7). |
| Step 116: | Remove the spacer 702 to create a canal 802 and etch down the STI region 212 inside the canal 802, and remove the oxide-2 layer 602 (FIG. 8). |
| Step 118: | Remove the thinner pad-nitride layer in the canal 802, deposit a thin SiCOH layer 902, deposit a thin oxide layer 904, and then use the CMP technique to polish the SiCOH layer 902, the oxide layer 904, the STI region 212, and the TiN layer 704/the W layer 706 (FIG. 9). |
| Step 120: | Etch down a top portion of the oxide layer 904 (or composite deep sidewall spacer), deposit a SiCOH layer 1202, use the CMP technique to polish the SiCOH layer 1202, and then remove the TiN layer 704/the W layer 706 (FIG. 10). |

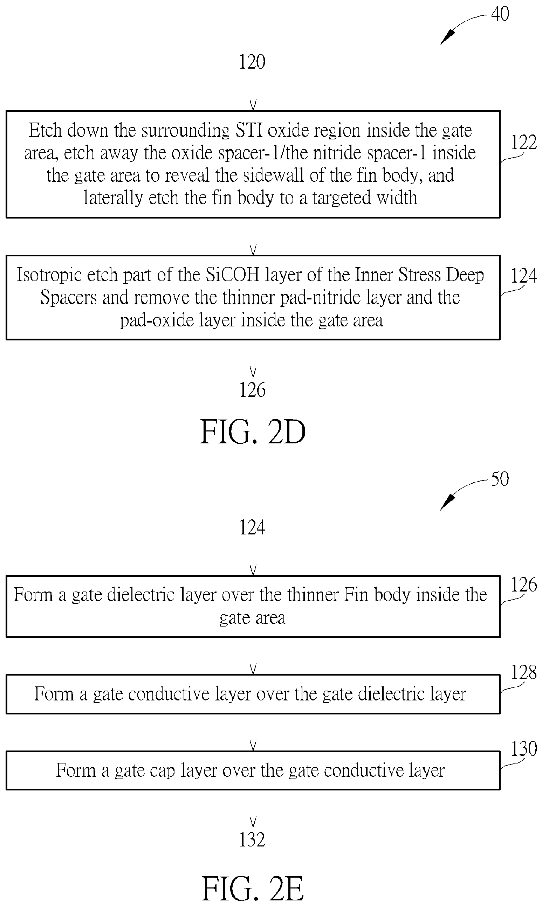

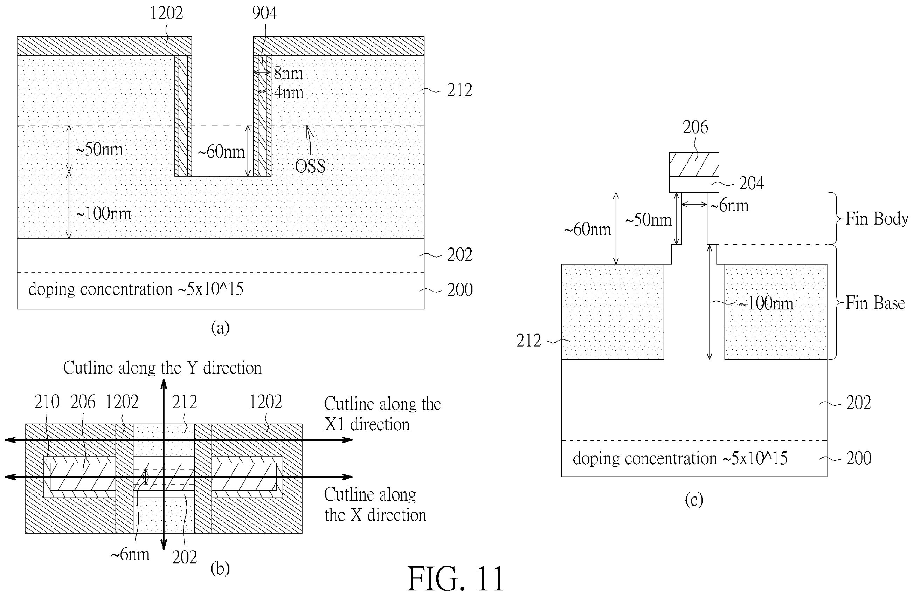

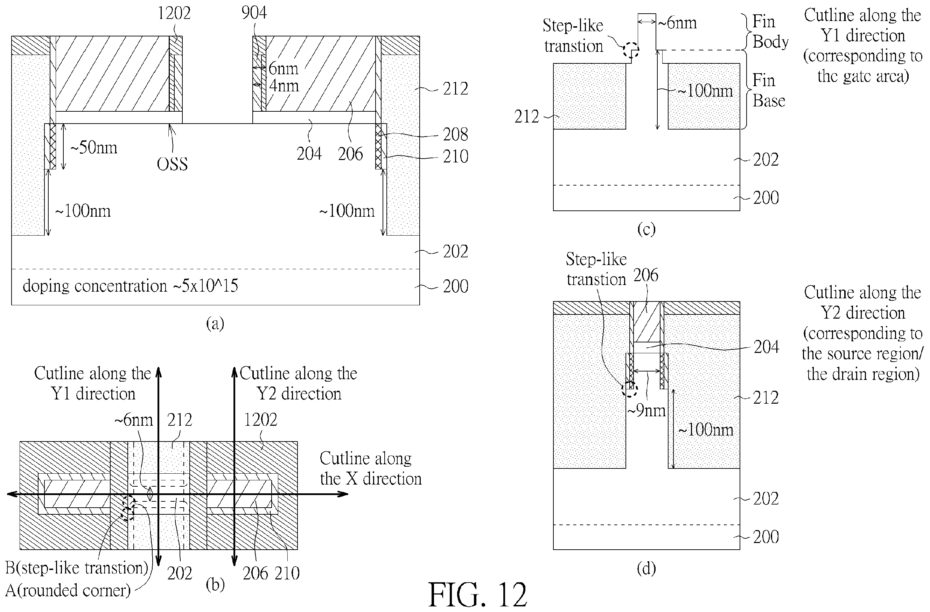

Please refer to FIG. 2D. FIG. 11, FIG. 12. Step 40 could include:

| | |
|---|---|
| Step 122: | Etch down the surrounding STI oxide region inside the gate area, etch away the oxide spacer-1 208/the nitride spacer-1 210 inside the gate area to reveal the sidewall of the fin body, and laterally etch the fin |
| | body to a targeted width (FIG. 11). |
| Step 124: | Isotropic etch part of the SiCOH layer 902 of the Inner Stress Deep Spacers and remove the thinner pad-nitride layer and the pad-oxide layer 204 inside the gate area (FIG. 12). |

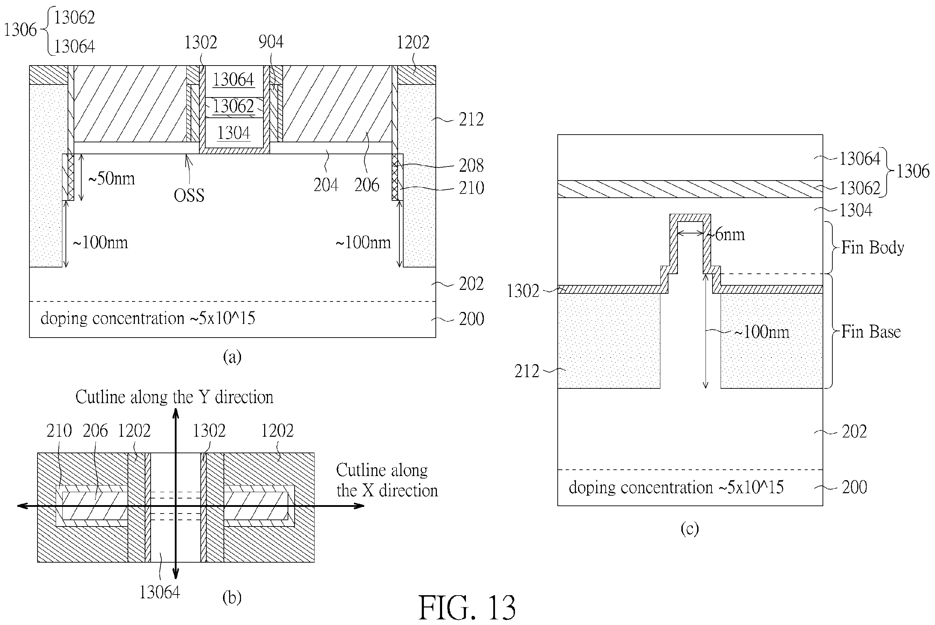

Please refer to FIG. 2E and FIG. 13. Step 50 could include:

| | |
|---|---|
| Step 126: | Form a gate dielectric layer 1302 over the thinner Fin body inside the gate area (FIG. 13). |
| Step 128: | Form a gate conductive layer 1304 over the gate dielectric layer 1302 (FIG. 13). |
| Step 130: | Form a gate cap layer 1306 over the gate conductive layer 1304 (FIG. 13). |

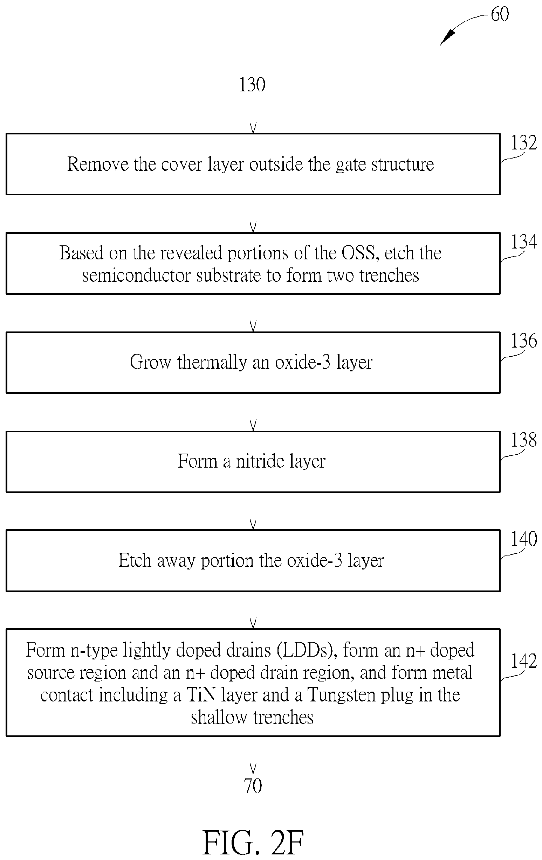

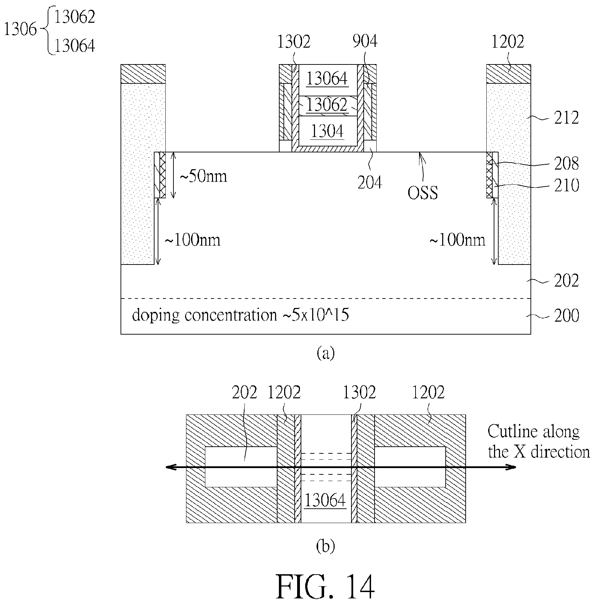

Please refer to FIG. 2F. FIG. 14, FIG. 15, FIG. 16, FIG. 17. Step 60 could include:

| | |
|---|---|
| Step 132: | Remove the cover layer outside the gate structure (FIG. 14). |
| Step 134: | Based on the revealed portions of the OSS, etch the semiconductor substrate to form two trenches 1502 (FIG. 15). |
| Step 136: | Grow thermally an oxide-3 layer 1504 (FIG. 15). |
| Step 138: | Form a nitride layer 1602 (FIG. 16). |
| Step 140: | Etch away portion the oxide-3 layer 1504 (FIG. 16). |
| Step 142: | Form n-type lightly doped drains (LDDs) 1702, form an n+ doped source region 1704 and an n+ doped drain region 1706, and form metal contact including a TiN layer 1708 and a Tungsten plug 1710 in the shallow trenches 1502 (FIG. 17). |

Start with a well-designed doped p-type well 202, wherein the p-type well 202 is installed in a p-type substrate 200 (wherein in another embodiment of the present invention, could start with the p-type substrate 200, rather than starting with the p-type well 202), wherein in one example, the p-type substrate 200 has concentration close to 5×10^15 dopants/cm^3, and the p-type substrate voltage (which is usually Grounded, i.e. 0 V) could be supplied across most of the body of the FinFET.

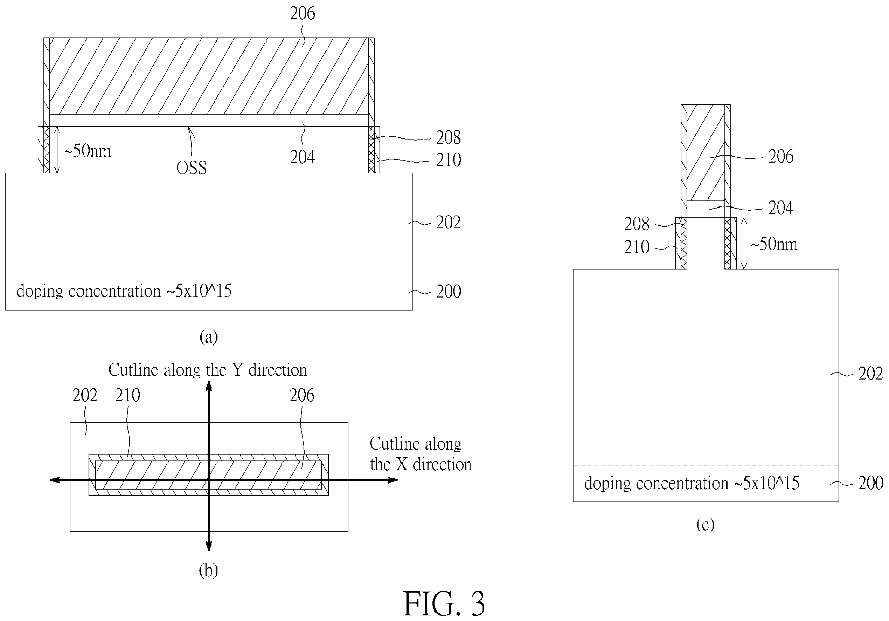

In Step 102, as shown in FIG. 3(a), grow thermally the pad-oxide layer 204 on an OSS (original silicon surface) and deposit the pad-nitride layer 206 on the pad-oxide layer 204. Then, use the photolithographic technique to define active regions in which the fin body of the FinFET will be allocated.

In Step 104, as shown in FIG. 3(a), based on the pad-nitride layer 206, the first etching process includes using an anisotropic etching technique to remove the pad-nitride layer 206 and the pad-oxide layer 204 out of the active region and then using a first dig-etching (such as Reactive Ion Etching, RIE) to dig silicon to make trenches formed in the silicon of the p-type well 202 with a depth about 50nm. In one embodiment of the present invention, a width of the pad-nitride layer 206 on the active region along a Y direction shown in FIG. 3(b) is 9nm in a process node of F=5nm and a space between two active regions is 9nm, which results in a pitch of 18nm = 3.6F. In another embodiment of the present invention, a width of the pad-nitride layer 206 on the active region along the Y direction could be 12nm in a process node of F=12nm and a space between two active regions is 12nm, which results in a pitch of 24nm = 2F. The aforesaid numbers are listed for illustration purpose and the present invention is not limited to those dimensions.

Then, in Step 106, as shown in FIG. 3(a), along the exposed silicon sidewalls, a thermal oxidation process is performed to form the thin oxide spacer-1 208 vertically outside the fin body, and form the vertical nitride spacer-1 210 outside the oxide spacer-1 208. The oxide spacer-1 208 and the nitride spacer-1 210 could protect a structure of the fin body. It is noticed that in one example the oxide spacer-1 208 is very thin and it barely affect a width of the fin width. In addition, FIG. 3(b) is a top view corresponding to FIG. 3(a), wherein FIG. 3(a) is a cross-section view along a cut line of an X direction shown in FIG. 3(b) and FIG. 3(c) is a cross-section view along a cut line of a Y direction shown in FIG. 3(b).

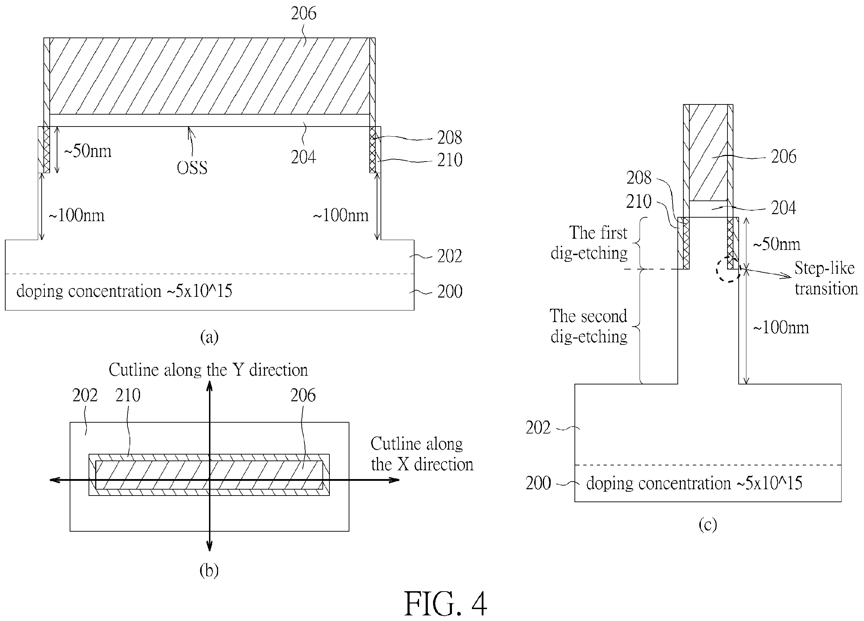

Then, in Step 108, as shown in FIG. 4(a), based on the pad-nitride layer 206 and the nitride spacer-1 210 as a mask, use an anisotropic etching technique (i.e. the second dig-etching) to remove the silicon (such as 100nm depth of the silicon) of the p-type well 202 to form a deeper trench, such that the depth of the deeper trench from the top of the OSS is around 150~200 nm. In addition, FIG. 4(b) is a top view corresponding to FIG. 4(a), wherein FIG. 4(a) is a cross-section view along a cut line of the X direction shown in FIG. 4(b) and FIG. 4(c) is a cross-section view along a cut line of the Y direction shown in FIG. 4(b). As shown in FIG. 4(c), due to the existence of the oxide spacer-1 208 and the nitride spacer-1 210, the perpendicular profile (along a direction (Z-axis) substantially perpendicular to the OSS) of the fin structure has a step-like transition between the portion of the fin structure formed by the first dig-etching and the portion of the fin structure formed by the second dig-etching. It could also be a non-gradual transition formed by different etching processes.

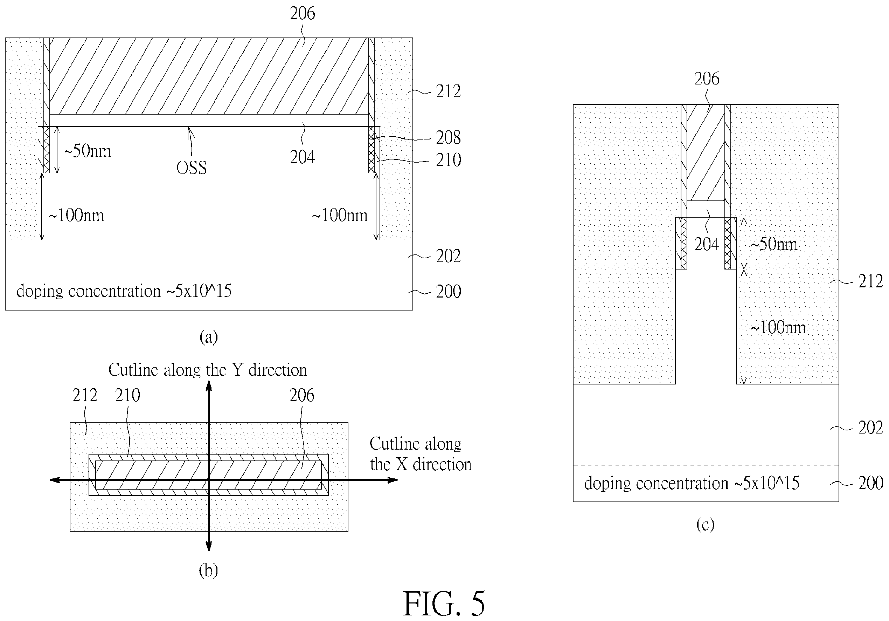

Then, in Step 110, as shown in FIG. 5(a), deposit a layer of oxide thick enough to fill in the deeper trench. Then, use a CMP (Chemical Mechanical Polishing) technique to remove the extra deposited oxide over a top of the pad-nitride layer 206 to form the shallow trench isolation (STI) 212 (or called STI region-1 or just STI-1), wherein a top surface of the STI region 212 is higher than the OSS, such as level up to the top of the pad-nitride layer 206. In addition, FIG. 5(b) is a top view corresponding to FIG. 5(a), wherein FIG. 5(a) is a cross-section view along a cut line of the X direction shown in FIG. 5(b) and FIG. 5(c) is a cross-section view along a cut line of the Y direction shown in FIG. 5(b).

Through the oxide spacer-1 208, the nitride spacer-1 210 and the STI region 212, the fin structure formed by the first dig-etching and the second dig-etching (referred to FIG. 4(c)) are well protected. In the conventional FinFET, the fin structure is formed just by one etching and the fin body looks like a trapezoidal shape (referred to FIG. 1), a width of the fin body is difficult to control and the fin body is easily collapsed. By the multiple silicon dig-etchings (i.e. the first dig-etching and the second dig-etching) and the protecting processes according to the present invention, the collapse of the fin structure during the etching process could be prevented, and the shape of fin structure is rectangular-like, especially the portion of the fin structure formed by the first dig-etching.

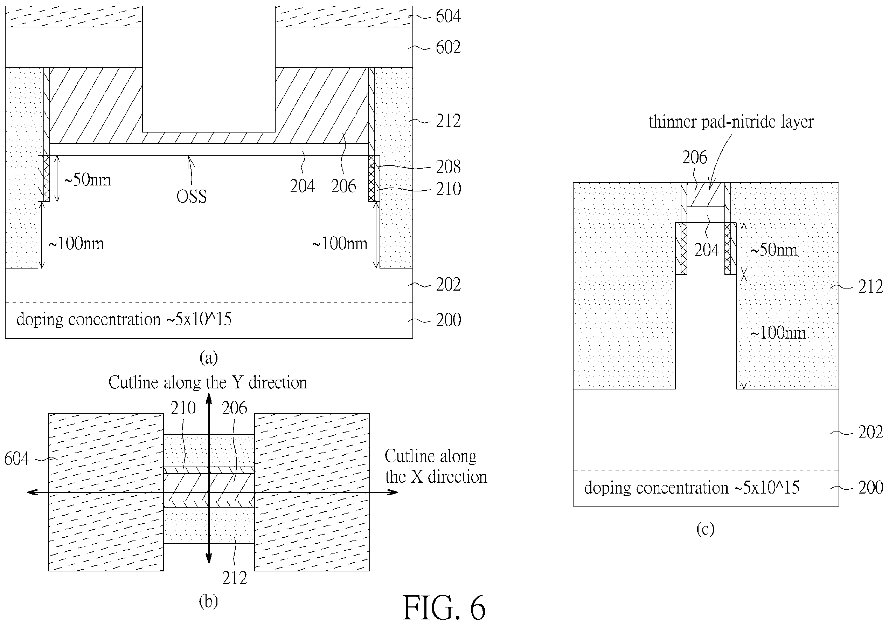

Described in the following is how to form the RB structure with a narrow fin body. In Step 112, as shown in FIG. 6(a), deposit the oxide-2 layer 602 and then use a photolithographic technique to define the gate area which is not protected by the photoresist layer 604. Then, use the photoresist layer 604 as a protection mask, the oxide-2 layer 602 inside the gate area is etched away, and the pad-nitride layer 206 inside the gate area then is made thinner (called a thinner pad-nitride layer). The STI region 212 inside the gate area is also etched away until to a depth of the bottom of the etched STI region to the top of the thinner pad-nitride layer (the etched STI region is named as thinner STI-1). In addition, FIG. 6(b) is a top view corresponding to FIG. 6(a), wherein FIG. 6(a) is a cross-section view along a cut line of the X direction shown in FIG. 6(b) and FIG. 6(c) is a cross-section view along a cut line of the Y direction shown in FIG. 6(b).

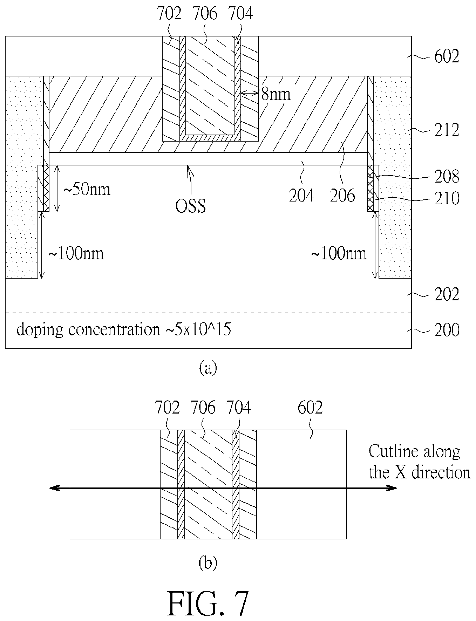

Then, in Step 114, as shown in FIG. 7(a), remove the photoresist layer 604. With a height difference from the original heights of the pad-nitride layer 206/the STI region 212 to both the thinner pad-nitride layer and the thinner STI-1, the spacer 702 (e.g. intrinsic amorphous silicon (or polysilicon) spacer with thickness 7~8nm) can be made on two sides of the pad-nitride layer 206 (that is, a thin layer of the intrinsic amorphous silicon is deposited inside the gate area and then use the anisotropic etching technique to etch the intrinsic amorphous silicon so that the spacer 702 is created). Then, deposit the TiN layer 704 and the Tungsten (W) layer 706 which is thick enough over a top surface of the thinner pad-nitride layer, and then use the CMP technique to polish the TiN layer 704 and the Tungsten layer 706 until the spacer 702 is exposed. In addition, FIG. 7(b) is a top view corresponding to FIG. 7(a), wherein FIG. 7(a) is a cross-section view along a cut line of the X direction shown in FIG. 7(b).

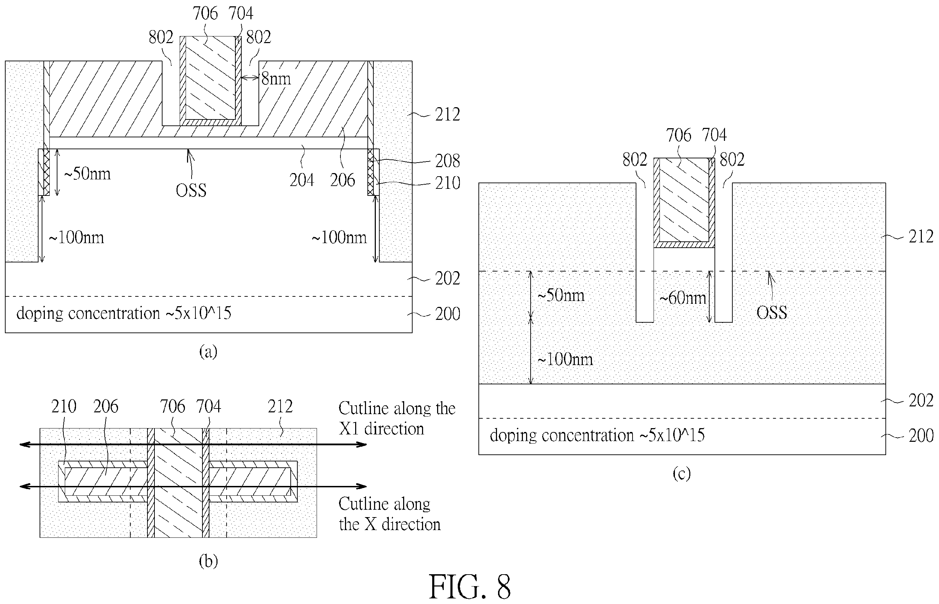

Then, in Step 116, as shown in FIG. 8(a), use the anisotropic etching technique to remove the spacer 702 and so the canal 802 is created between the TiN layer 704 and the pad-nitride layer 206, and a bottom of the canal 802 sits on the thinner STI-1 in the active region and the thinner pad-nitride layer over the part of the silicon in the active region, respectively, along the longitudinal gate direction (can be referred to a direction of the cut line of the Y direction shown in FIG. 6(b)). Thereafter, use the anisotropic etching technique to remove the STI region 212 inside the canal 802 (but outside the active region) down about a distance deeper than the depth of the fin body (e.g. ~60 nm deep). The oxide-2 layer 602 could be also removed in Step 116. In addition, FIG. 8(b) is a top view corresponding to FIG. 8(a), wherein FIG. 8(a) is a cross-section view along a cut line of the X direction shown in FIG. 8(b) and FIG. 8(c) is a cross-section view along a cut line of the X1 direction shown in FIG. 8(b).

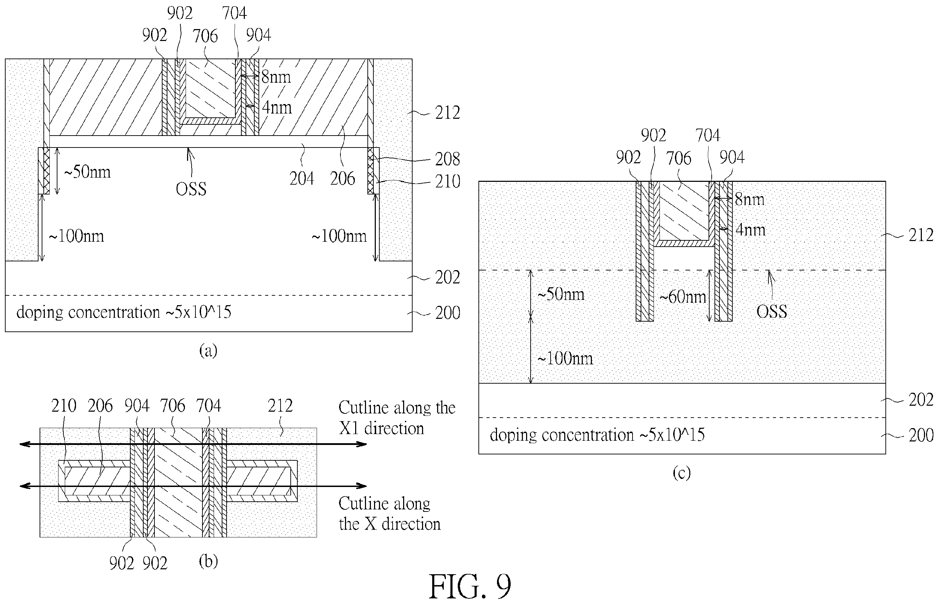

Then, in Step 118, as shown in FIG. 9(a), remove the thinner pad-nitride layer in the canal 802 until the pad-oxide layer 204 is exposed, wherein the pad-oxide layer 204 is over the OSS. Then, deposit the SiCOH layer 902 which falls into the canal 802 on two edges but not thick enough to conceal the canal 802 (e.g. ~2nm thickness, so a vacant canal is left with a width about 4nm).

Then, as shown in FIG. 9(a), deposit the oxide layer 904 to completely fill the vacant canal. Afterward, use the CMP technique to polish the SiCOH layer 902/the oxide layer 904 over the top of the pad-nitride layer 206, the STI region 212, and the TiN layer 704/the W layer 706. The SiCOH layer 902 and the oxide layer 904 (e.g. 2nm SiCOH layer + 4nm oxide layer in the middle + 2nm SiCOH layer) form a composite deep sidewall spacer below the OSS down to surround the depth of the fin body and sit on a top of the pad-oxide layer 204 over both the OSS and the deep fin shape inside the canal 802. Such composite deep sidewall spacer could provide stress and could be called as Inner Stress Deep Spacers. In addition, FIG. 9(b) is a top view corresponding to FIG. 9(a), wherein FIG. 9(a) is a cross-section view along a cut line of the X direction shown in FIG. 9(b) and FIG. 9(c) is a cross-section view along a cut line of the X1 direction shown in FIG. 9(b).

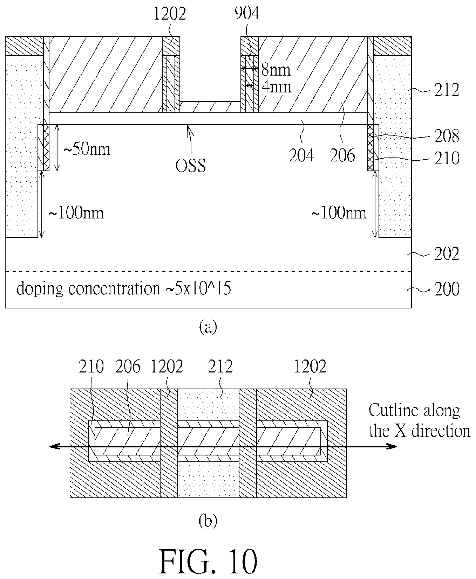

Afterward, in Step 120, as shown in FIG. 10(a), use an anisotropic etching technique to etch down the top portion (e.g. ~5nm thick) of the oxide layer 904 (or the composite deep sidewall spacer) to leave an canal over the composite deep sidewall spacer. Then, deposit the SiCOH layer 1202 (e.g. 2nm thick) to completely fill the top canal over the composite deep sidewall spacer. Then, use the CMP technique to remove a top of the SiCOH layer 1202 until the top of the TiN layer 704/the W layer 706, the top of the SiCOH layer 1202, and the pad-nitride layer 206 become a flat surface.

Then, remove the TiN layer 704/the W layer 706, so that the exposed area from the top view (as shown in FIG. 10(b)) shows the thin pad-nitride layer in the gate area, a surrounding lower oxide region (i.e. the STI region 212) inside the gate area, and the Inner Stress Deep Spacers with a SiCOH cap (i.e. the SiCOH layer 1202). In addition, FIG. 10(b) is a top view corresponding to FIG. 10(a), wherein FIG. 10(a) is a cross-section view along a cut line of the X direction shown in FIG. 10(b).

### Option 1: With fin Thinning

Then, in Step 122, as shown in FIG. 11(a), etch down the surrounding STI oxide region (i.e. the STI region 212) inside the gate area until its top surface is under the OSS around 60 nm, such that the fin body covered by the oxide spacer-1 208/the nitride spacer-1 210 is revealed, so is part of the fin base.

Then, as shown in FIG. 11(c), etch away the oxide spacer-1 208/the nitride spacer-1 210 inside the gate area to reveal sidewalls of the fin body. Carry out a lateral etching technique for removing the exposed silicon in the fin body/the fin base between two Inner Stress Deep Spacers in order to thinning the fin body to a targeted width (e.g. laterally remove ~3nm silicon on each side so that the remaining lateral width of the fin body inside the gate area is narrowed down to ~6nm; but the width of the fin body below the pad-nitride layer 206/the pad-oxide layer 204 in the other active region (outside the gate area) remains ~12nm). Therefore, even the fin body in the gate area is thinned, the remaining fin body extended laterally to two ends of the active region is still protected by the oxide spacer-1 208, the nitride spacer-1 210 and the STI region-1, so is the fin base. Thus, it could effectively prevent the thinned fin body from collapse. In addition, FIG. 11(b) is a top view corresponding to FIG. 11(a), wherein FIG. 11(a) is a cross-section view along a cut line of the X1 direction shown in FIG. 11(b) and FIG. 11(c) is a cross-section view along a cut line of the Y direction shown in FIG. 11(b). In addition, a cross-section view along a cut line of the X direction shown in FIG. 11(b) can be referred to FIG. 10(a).

Then, in Step 124, as shown in FIG. 12(a), isotropic etch part of the SiCOH layer 902 of the Inner Stress Deep Spacers around 1~2nm to reveal silicon area underneath. It is noted that the silicon underneath and around the SiCOH layer 902 of the Inner Stress Deep Spacers may be removed and is ended up a rounded corner (e.g. ~ 2nm = 66% of 3nm due to fin thinning effect), which is about the thickness of the SiCOH layer 902, as marked by a circle A in FIG. 12(b). Furthermore, the lateral profile (along the X direction) of the fin structure further provides a step-like transition or a non-gradual transition after the rounded corner, as marked by a circle B in FIG. 12(b). Then, remove the thinner pad-nitride layer and the pad-oxide layer 204 above the top portion of the narrow fin structure (e.g. ~6nm width of the fin structure for the semiconductor transistor body). In addition, FIG. 12(b) is a top view corresponding to FIG. 12(a), wherein FIG. 12(a) is a cross-section view along a cut line of the X direction shown in FIG. 12(b), FIG. 12(c) is a cross-section view along a cut line of the Y1 direction shown in FIG. 12(b), FIG. 12(d) is a cross-section view along a cut line of the Y2 direction shown in FIG. 12(b), and FIG. 12(c) corresponds to the gate area and FIG. 12(d) corresponds to the source region/the drain region.

Thereafter, form the EOT (equivalent oxide thickness) ~1.2nm, such as HK material, on both the top and the sidewalls of the fin structure. The EOT is also formed on the aforementioned corner rounded regions as deep as where the thinner fin body is exposed. So the channel regions are on the two sides of the narrow fin structure with a small rounded extension to the wider fin area underneath the composite deep sidewall spacer. From top-view on the EOT into the channel and body regions of the narrow fin structure, the silicon body is all p-substrate until where the LDD (Lightly doped drain) n-type doped has been formed. So there is no the thin EOT and no extra gate-to-drain/source capacitances formed between the gate and drain/source regions. With the right design of forming the edge of the LDD regions to the gate area there is less concern about either underlapping or overlapping between the gate and the drain/source regions.

Then, in Step 126, as shown in FIG. 13(a), the gate dielectric layer 1302 (e.g. Hi-k/oxide gate dielectric material) is formed in the gate area. Thereafter, in Step 128, as shown in FIG. 13(a), the gate conductive material (e.g. N+ polysilicon) 1304 is deposited and then CMP/etch back the gate conductive material 1304. Thereafter, in Step 130, as shown in FIG. 13(a), deposit a nitride layer 13062 and a Hard Mask oxide (HM_oxide) layer 13064 of the gate cap layer 1306 and then CMP the HM_oxide layer 13064 and the nitride layer 13062 such that a top of the HM_oxide layer 13064 is aligned with the pad-nitride layer 206, wherein the gate dielectric layer 1302, the gate conductive material 1304, and the gate cap layer 1306 act as the gate structure. In addition, FIG. 13(b) is a top view corresponding to FIG. 13(a), wherein FIG. 13(a) is a cross-section view along a cut line of the X direction shown in FIG. 13(b), and FIG. 13(c) is a cross-section view along a cut line of the Y direction shown in FIG. 13(b).

The following describes an example to form the source/drain regions. In Step 132, as shown in FIG. 14(a), remove the cover layer (the pad-nitride layer 206 and the pad-oxide layer 204) outside the gate structure to reveal the silicon surface, and some the STI region 212 and the HM_oxide layer 13064 may be removed as well. It is noticed that the top of the STI region 212 (along the X direction shown in FIG. 14(b)) is higher than the OSS, and such the higher STI region 212 could be helpful to limit the formation of the source/drain regions by selective growth described later. In addition, FIG. 14(b) is a top view corresponding to FIG. 14(a), wherein FIG. 14(a) is a cross-section view along a cut line of the X direction shown in FIG. 14(b).

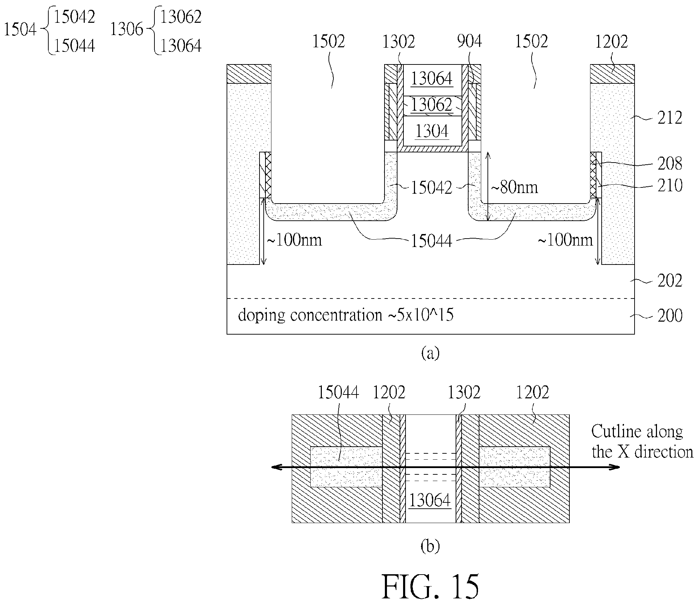

Then, in Step 134, as shown in FIG. 15(a), etch away some exposed silicon to create shallow trench 1502 (e.g. about 80nm deep) for the source/drain regions.

Then, in Step 136, as shown in FIG. 15(a), use a thermal oxidation process, called as oxidation-3 process, to grow the oxide-3 layer 1504 (including both an oxide-3V layer 15042 penetrating the vertical sidewalls of the semiconductor transistor body (assuming with a sharp crystalline orientation <110>) and an oxide-3B layer 15044 on top of the bottoms of the shallow trenches 1502 corresponding to the source/drain regions), and the oxidation-3 process grows little oxide (i.e. the oxide-3 layer 1504) on these walls such that the width of the source/drain regions is not really affected by the oxidation-3 process, wherein as shown in FIG. 15(a), the thickness of the oxide-3V layer 15042 and the oxide-3B layer 15044 and following figures are only shown for illustration purpose, and its geometry is not proportional to the dimension of the STI region 212 shown in those figures. For example, the thickness of the oxide-3V layer 15042 and the oxide-3B layer 15044 is around 10-20 nm, but the vertical height of the STI region 212 could be around 150~200 nm. But it is very important to design the oxidation-3 process such that the thickness of the oxide-3V layer 15042 can be very accurately controlled under both precisely controlled thermal oxidation temperature, timing and growth rate. Since the thermal oxidation over a well-defined silicon surface should result in that 40% of the thickness of the oxide-3V layer 15042 taken away the thickness of the exposed <110> silicon surface in the vertical wall of the semiconductor transistor body and the remaining 60% of the thickness of the oxide-3V layer 15042 be counted as an addition outside the vertical wall of the semiconductor transistor body. In addition, FIG. 15(b) is a top view corresponding to FIG. 15(a), wherein FIG. 15(a) is a cross-section view along a cut line of the X direction shown in FIG. 15(b).

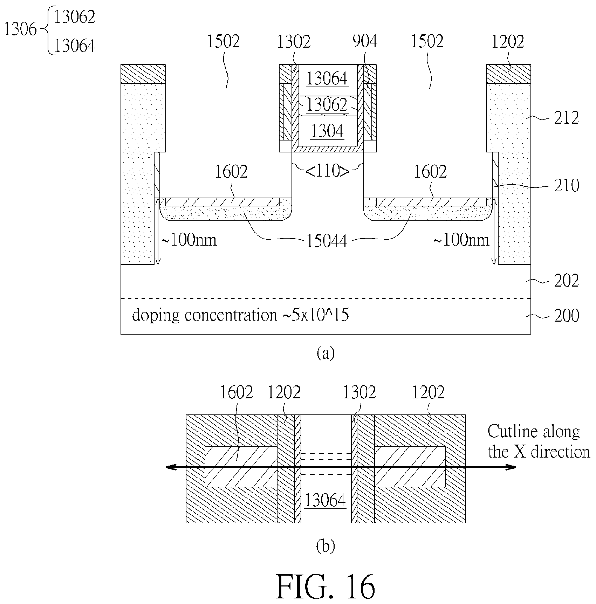

Then, in Step 138, as shown in FIG. 16(a), use CVD nitride deposition and then etching back to form the nitride layer 1602 on the top of the oxide-3B layer 15044. (In another embodiment of the present invention, it is optional to further deposit Tungsten and etch back to form a Tungsten layer on the top of the nitride layer 1602. Then deposit and etch back TiN to form the TiN layer above the Tungsten layer, such that the top of the TiN layer is lower than OSS around 20∼40nm).

Then, in Step 140, as shown in FIG. 16(a), carry out an etching process to etch the oxide-3 layer 1504, especially the oxide-3V layer 15042, to reveal the crystalline orientation <110> of the silicon region and the width of the revealed crystalline orientation <110> silicon could be around 9nm which is larger than the width (~6nm) of the fin body under the gate. In addition, FIG. 16(b) is a top view corresponding to FIG. 16(a), wherein FIG. 16(a) is a cross-section view along a cut line of the X direction shown in FIG. 16(b).

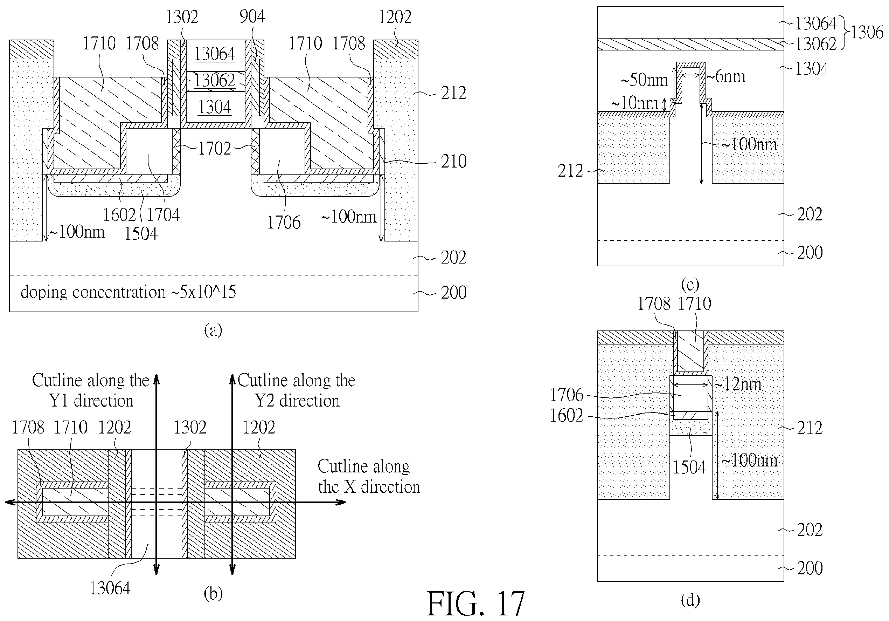

Thereafter, in Step 142, as shown in FIG. 17(a), use a selective growth technique (such as selective epitaxy growth (SEG) technique) to form the n-type LDD 1702, the n+ doped source region 1704, and the n+ doped drain region 1706, respectively from the revealed crystalline orientation <110> of the silicon region. It is possible to anneal the grown n-type LDD 1702 and/or the n+ doped source and drain regions 1704, 1706, such that the interface between the n-type LDD 1702 and the p-type substrate material of the p-type well 202 is close to the narrower channel region. To be mentioned, no ion-implantations for forming all channel, drain and source regions are needed, and no high temperature and long thermal annealing is required to remove those damages due to heavy bombardments of forming these regions. Furthermore, since the top surface of the STI region 212 is higher than the OSS, the selectively grown the n-type LDD 1702, the n+ doped source region 1704, and the n+ doped drain region 1706 are limited by the higher STI region 212 without growing over the STI regions and have the well-grown <110> crystalline silicon structure.

Finally, deposit a TiN layer 1708 and then a Tungsten plug 1710 to fill in the shallow trenches 1502 corresponding to the source/drain regions to form the metal contact. Thus, the metal contact is self-aligned with the n+ doped drain region 1706 without using additional photolithographic process to form contact hole. Up to now, the height of the n+ doped source region 1704 and the n+ doped drain region 1706 is around 40-50nm, and the n+ doped source region 1704 and the n+ doped drain region 1706 are surrounded by the TiN layer 1708 and Tungsten plug 1710 at least two sides (top side and one most lateral sidewall), so the contact resistance is dramatically reduced. Furthermore, since the STI region 212 corresponding to the gate area is etched down around 60-80nm from the top of the OSS, the bottom (can be referred to FIG. 11(b)) of the gate structure (over the STI region 212) could be lower than the bottoms of the n+ doped source region 1704 and the n+ doped drain region 1706 around 10-20nm, such that the loff could be reduced as well. In addition, FIG. 17(b) is a top view corresponding to FIG. 17(a), wherein FIG. 17(a) is a cross-section view along a cut line of the X direction shown in FIG. 17(b), FIG. 17(c) is a cross-section view along a cut line of the Y1 direction shown in FIG. 17(b), FIG. 17(d) is a cross-section view along a cut line of the Y2 direction shown in FIG. 17(b), and FIG. 17(c) corresponds to the gate area and FIG. 17(d) corresponds to the n+ doped drain region 1706. In addition, it is clear that the fin body inside the gate area has a narrower width (e.g. 6nm, as shown in FIG. 17(c)) and the n+ doped source region 1704 (the n+ doped drain region 1706) has a wider width (e.g. 12nm, as shown in FIG. 17(d)). Since the width of the n+ doped source region 1704 (the n+ doped drain region 1706) is wider than that of the fin body inside the gate area, the resistance of the n+ doped source region 1704 (the n+ doped drain region 1706) could be controlled within an acceptable range, and the wider the n+ doped source region 1704 (the n+ doped drain region 1706) is helpful for metal contact as well.

Although in the above-mentioned embodiment, the gate structure is firstly formed before the formation of the n+ doped source region 1704/the n+ doped drain region 1706, it is well-known that the "gate-Last" process can be performed in the present invention without difficulties and no needed to elaborate here.

### Option 2: Without fin Thinning

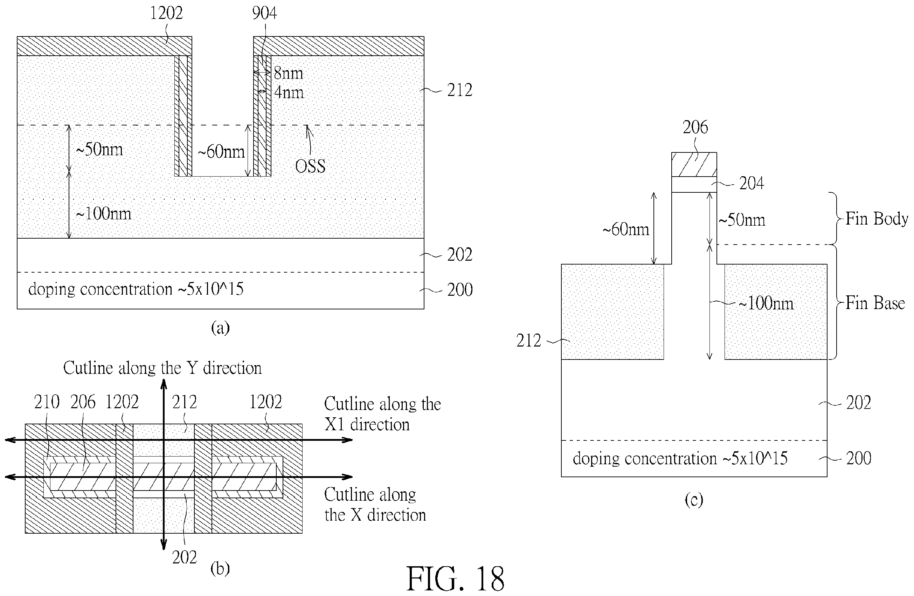

The above-mentioned processes, especially the Inner Stress Deep Spacers, could be applied to the fin structure without thinning. Following the above-mentioned FIG. 10, etch down the surrounding lower oxide region inside the gate area until its top surface is under the OSS around 60 nm (as shown in FIG. 18(a)), such that the fin body covered by the oxide spacer-1 208/the nitride spacer-1 210 is revealed, so is part of the fin base. Then etch away the oxide spacer-1 208/the nitride spacer-1 210 to reveal sidewalls of the fin body (as shown in FIG. 18(c)). In addition, FIG. 18(b) is a top view corresponding to FIG. 18(a), wherein FIG. 18(a) is a cross-section view along a cut line of the X1 direction shown in FIG. 18(b), and FIG. 18(c) is a cross-section view along a cut line of the Y direction shown in FIG. 18(b). In addition, as shown in FIG. 18(b), a cross-section view along a cut line of the X direction can be referred to FIG. 10(b), so further description thereof is omitted for simplicity.

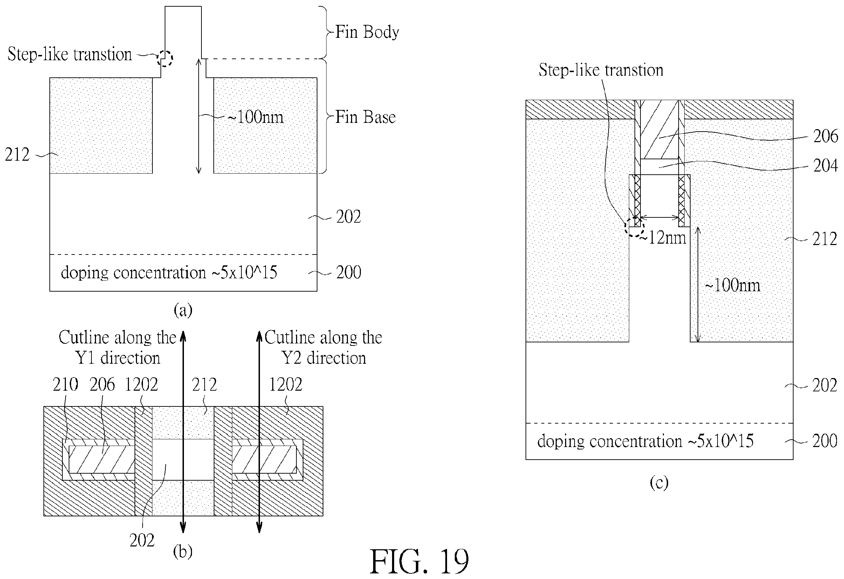

Then, as shown in FIG. 19(b), remove the thinner pad-nitride layer and the pad-oxide layer 204 above the top portion of the narrow fin structure (e.g. ~6nm width of the fin for the semiconductor transistor body). In addition, FIG. 19(b) is a top view corresponding to FIG. 19(a), wherein FIG. 19(a) is a cross-section view along a cut line of the Y direction shown in FIG. 19(b), and FIG. 19(c) is a cross-section view along a cut line of the Y2 direction shown in FIG. 19(b). In addition, as shown in FIG. 19(b), a cross-section view along a cut line of the X direction can be referred to FIG. 12(a), so further description thereof is omitted for simplicity.

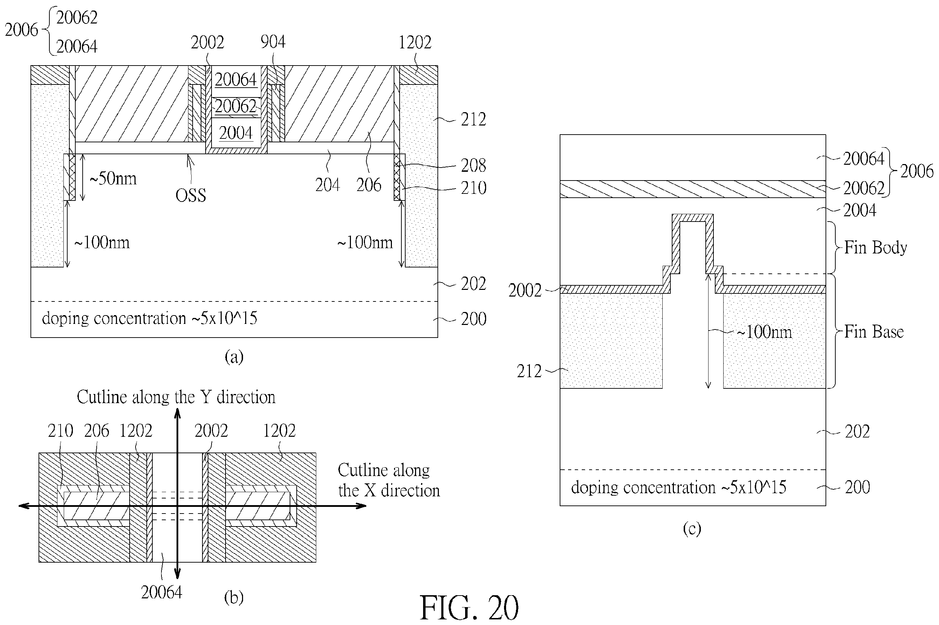

Thereafter, as shown in FIG. 20(a), a gate dielectric layer 2002 (e.g. Hi-k/oxide gate dielectric material) is formed in the defined gate area, and a gate conductive material (e.g. N+ polysilicon) 2004 is deposited and then CMP/etch back the gate conductive material 2004. Thereafter, deposit a nitride layer 20062 and a Hard Mask oxide (HM_oxide) layer 20064 of a gate cap layer 2006 and then CMP the nitride layer 20062 and the Hard Mask oxide layer 20064 such that a top of the HM_oxide layer 20064 is aligned with the pad-nitride layer 206. In addition, FIG. 20(b) is a top view corresponding to FIG. 20(a), wherein FIG. 20(a) is a cross-section view along a cut line of the X direction shown in FIG. 20(b), and FIG. 20(c) is a cross-section view along a cut line of the Y direction shown in FIG. 20(b). The later processes to form the source/drain regions are just the same as those described in FIG. 14, FIG. 15, FIG. 16, FIG. 17, and will not be repeatedly illustrated.

In summary, a 3D transistor structure with precise width and solid base of its fin body is disclosed. The fin body could be solid and not easily bent as the dimension is getting narrower due to scaling. Furthermore, the new 3D FET structure can have a smaller fin Pitch since the source/drain regions are well-confined during the formation, thus reducing the area of the semiconductor transistor so as to getting closer to meet the demands from the Moore's Law of more transistors per unit area and lower cost per transistor. The contact resistance of the source/drain regions with the metal plug is lower as well since the doped source and drain are surrounded by the Tungsten layers at least three sides. Moreover, the perpendicular profile (Z-direction) of the fin structure has a step-like transition, and the fin body region is a rectangular shape. The width of the fin body in the channel region or gate area is well-controlled by the aforesaid fin Thinning oxidation, thus, inside the channel region there is a narrow body width (fin body as channel, e.g. 6nm) and the other wide one which is reserved for source/drain regions (fin body as S/D, e.g. 9nm). Therefore, the lateral profile (X direction) of the invented fin body has a step-like transition as well.

Compared with the conventional FinFET structure, the proposed FinFET structure according to the present invention has following advantages:
(1)Inner Stress Deep Spacer is formed or filled in canal, and the width of the Inner Stress Deep Spacer is limited by the width of the canal.
(2)The shape and dimension of the fin body in the conventional FinFET structure is difficult to be controlled. However, the dimension and the shape of the fin body in the gate structure according to the present invention are well-controlled. The width of the fin body in the gate structure is well-controlled by lateral etching processes (e.g. the width of the fin body could be easily controlled within 3-6nm even the technology node is more than 10nm). Moreover, the depth of the fin body in the gate structure is easily controlled as well by the first dig-etching mentioned in FIG. 4(c). Thus, the fin body of the present invention in the gate structure could be a rectangle-like shape in Y-direction profile, and there is a rounded corner between the thinned fin body and the source/drain regions in the in X direction profile.
(3)The fin structure in the conventional FinFET structure is easily collapsed, especially when the technology node is down to 10nm or lower. Nevertheless, in the present invention, the fin body and the fin based are formed or defined by separate etching Steps, and even the fin body in the gate area is thinned, the remaining fin body extended laterally to two ends of the active region is still protected by the oxide spacer-1, the nitride spacer-1, and the STI region, so it is hardly to collapse. Moreover, the fin base under the fin body is fully surrounded by the STI region such that the fin base is a solid base.
(4)The crystalline structure and the dimension of the source/drain regions of the conventional FinFET (no matter by ion implantation or selective growth) are difficult to be controlled. On the other hand, in the present invention, the n-type LDD and the n+ doped source and drain regions are only selectively grown based on <110> crystalline structure. Furthermore, since the top of the STI region is higher than the OSS, the selectively grown n-type LDD and n+ doped source and drain regions are limited by the higher STI region regions without growing over the STI region regions.
(5)In the present invention, since the width of the source/drain regions is wider than that of the fin body inside the gate area, the resistance of the source/drain regions could be controlled within an acceptable range, and the wider source/drain regions is helpful for metal contact as well.
(6)There is no extra gate-to-D/S capacitances formed between the gate and the drain/source regions. With the right design of forming the edge of the n-type LDD regions to the gate area there is less concern about either underlapping or overlapping between the gate and the drain/source regions.

## Claims

1. A semiconductor transistor comprising:
a semiconductor substrate with an original surface;
an active region formed based on the semiconductor substrate, the active region having a fin structure;
a shallow trench isolation region surrounding the active region, and a gate structure of the semiconductor transistor crossing over the fin structure;
a first conductive region and a second conductive region of the semiconductor transistor located within the active region; and
a spacer contacted to a sidewall of the gate structure and on the fin structure;
**characterized by**:
wherein a width of the fin structure under the spacer is wider than that of the fin structure under the gate structure, the fin structure has a lateral profile along a direction substantially parallel to the original surface, and the lateral profile of the fin structure comprises a rounded corner under the spacer.

2. The semiconductor transistor of claim 1, further **characterized in that** the first conductive region is limited by the shallow trench isolation region, and a width of the first conductive region is wider than that of the fin structure under the gate structure.

3. The semiconductor transistor of claim 1, further **characterized in that** the fin structure comprises a fin body and a fin base, the fin structure has a perpendicular profile along a direction substantially perpendicular to the original surface, and the perpendicular profile comprises a step-like transition or non-gradual transition between the fin body and the fin base.

4. The semiconductor transistor of claim 3, further **characterized in that** the lateral profile of the fin structure further provides another step-like transition or a non-gradual transition between the fin structure under the gate structure and the rounded corner.

5. The semiconductor transistor of claim 1, further **characterized in that** the first conductive region is contacted to a first end of the fin structure, the second conductive region is contacted to a second end of the fin structure, and the first conductive region and the second conductive region are independent from the fin structure.

6. The semiconductor transistor of claim 1, further **characterized in that** a bottom of the gate structure over the shallow trench isolation region is lower than a bottom of the first conductive region and/or the second conductive region.

7. The semiconductor transistor of claim 1, further **characterized in that** at least two sides of the first conductive region or the second conductive region are contacted to a metal-containing region.

8. A manufacture method for a semiconductor transistor, comprising:
based on a semiconductor substrate, forming a fin structure which comprises a fin body and a fin base;
forming a gate structure over the fin structure; forming a gate spacer over the fin structure; and
**characterized by**:
controlling a width of the fin body in the gate structure, such that the width of the fin body in the gate structure and outside the gate spacer is narrower than that of the fin body under the gate spacer, wherein the fin structure has a lateral profile along a direction substantially parallel to the original surface, and the lateral profile of the fin structure comprises a rounded corner under the gate spacer.

9. The manufacture method of claim 8, further **characterized in that** the Step of forming the fin structure comprises:
defining the fin structure by a pad cover layer;
based on the pad cover layer, using a first etching process to etch the semiconductor substrate to form the fin body; and
forming a side spacer layer to cover sidewalls of the fin body; and based on the pad cover layer and the spacer layer, using a second etching process to further etch the semiconductor substrate to form the fin base.

10. The manufacture method of claim 9, further **characterized in that** the Step of forming the gate structure comprises:
forming a STI region to surround the fin structure, wherein a top surface of the STI region is higher than an original surface of the semiconductor substrate;
defining the gate structure by a patterned photo-resistance; and
etching down portion of the STI region and portion of the pad cover layer in the gate structure.

11. The manufacture method of claim 10, further **characterized in that** the Step of forming the gate spacer over the fin structure comprises:
forming a polysilicon spacer covering sidewalls of the gate structure;
forming a TiN layer and a Tungsten material to fill in rest portion of the gate structure;
removing the polysilicon spacer to form canals in the gate structure; etching down the STI region within the canals; and
forming the gate spacer to fill in the canals; and removing the TiN layer and the Tungsten material.

12. The manufacture method of claim 11, further **characterized in that** the Step of controlling the width of the fin body in the gate structure comprises:
etching down the STI region in the gate structure;
removing the side spacer layer within the gate structure to reveal sidewalls of the fin body; and
laterally etching the fin body, such that the width of the fin body in the gate structure and outside the gate spacer is narrower than that of the fin body under the gate spacer.

13. The manufacture method of claim 12, further **characterized in that**:
removing the pad cover layer within the gate structure to reveal a top surface of the fin body;
forming a EOT (Equivalent oxide Thickness) spacer on both the top surface and the sidewalls of the fin body; and
forming a gate structure to cover the top surface and the sidewalls of the fin body and the sidewall of the fin base in the gate structure; wherein the gate structure comprises a gate dielectric layer and a gate conductive layer covering the fin body, the fin base, and the STI region within the defined gate structure.

14. The manufacture method of claim 13, further **characterized in that**:
removing the pad cover layer outside the defined gate structure to reveal a first portion of the original surface of the semiconductor substrate; based on the first portion of the original surface, etching the semiconductor substrate to form a first trench; and
based on the first trench, forming a first conductive structure of the semiconductor transistor.

15. The manufacture method of claim 14, further **characterized in that** the Step of forming the first conductive structure comprises:
forming a covering oxide layer based on the surface of the first trench; etching portion of the covering oxide layer to form a revealed sidewall of the semiconductor substrate;
forming a doped semiconductor structure based on the revealed sidewall of the semiconductor substrate, wherein the doped semiconductor structure is confined by the STI region; and
forming a metal structure to fill in the first trench and contact the doped semiconductor structure.

16. The manufacture method of claim 15, further **characterized in that** the doped semiconductor structure comprises a lightly doped semiconductor region and a highly doped semiconductor region.
